# EUROPEAN PATENT APPLICATION

(11) **EP 4 707 670 A2**
(43) Date of publication of application: **11.03.2026**
(21) Application number: 26153459.8
(22) Date of filing: 11.04.2023
(51) Int. Cl.: F21V 21/04

(54) **A FITTING FOR MOUNTING A BUILDING CONTROL SENSOR**

(30) Priority: 12.04.2022 GB 202205361
(62) Divisional of application: 23719447.7
(71) Applicant: Cucumber Lighting Controls Limited, Coventry West Midlands CV1 2TL (GB)
(72) Inventor: MANS, Paul, Coventry, CV1 2TL (GB)
(74) Representative: HGF

(57) **Abstract**

The present disclosure provides a fitting (2) for mounting a building control sensor (3) to a surface. The fitting (2) comprises a mounting hole (4) for screwing the fitting (2) to the surface. The fitting (2) also comprises a spring retaining clip (5) adapted to retain the fitting (2) within a hole formed in the surface. The fitting (2) can therefore be surface mounted, or hole mounted. The present disclosure also provides a shield attachment (29) for a building control sensor (3) having a housing (22) and a lens (23). The shield attachment (29) comprises a frame (30) attachable to the building control sensor (3) and a shield element (24) movably mounted to the frame (30) and movable relative to the lens (23) of the building control sensor (3) to adjust a field of view of the building control sensor (3). Accordingly, the field of view of the building control sensor (3) can be adjusted according to the specific installation site.

## Description

### TECHNICAL FIELD

The present invention relates to a fitting for mounting a building control sensor to a surface. The present invention also relates to a shield attachment for a building control sensor.

### BACKGROUND

Fittings for building control sensors, for example lighting control sensors or fire alarms, can be either surface-mounted fittings or hole-mounted fittings. Surface-mounted fittings have holes for screwing the surface-mounted fitting to a surface. Hole-mounted fittings have some kind of retaining clip, usually a spring retaining clip.

Some building control sensors (for example motion detectors) have a lens that defines a field of view of the sensor. The field of view of such sensors often needs to be changed or adjusted on installation, for example to only cover a particular area such as a corridor. The field of view can be changed by covering a part of the lens with a sticky label or a shield which is cut to the required size.

It is an aim of certain examples of the present invention to solve, mitigate or obviate, at least partly, at least one of the problems and/or disadvantages associated with the prior art.

### SUMMARY OF THE INVENTION

According to a first aspect of the present invention there is provided a fitting for mounting a building control sensor to a surface, the fitting comprising:
a mounting hole for screwing the fitting to the surface, and,
a spring retaining clip adapted to retain the fitting within a hole formed in the surface.

Accordingly, the fitting can be configured for surface-mounting (using the mounting holes) or for hole-mounting (using the spring retaining clips). Advantageously this can reduce the number of different parts that need to be manufactured, and the fitting can be adapted for the specific installation at the installation site.

In examples, the spring retaining clip is removeable. In examples, the spring retaining clip is at least partly aligned with the mounting hole. The spring retaining clip may prevent use of the mounting hole until the spring retaining clip is removed.

In examples, the spring retaining clip is mounted in a recess of the fitting. In examples, the mounting hole may extend from the recess.

In examples, the fitting comprises a mounting surface arranged to abut the surface when using the mounting hole. The mounting hole may be perpendicular to the mounting surface. The mounting surface may be planar.

In examples, the fitting may comprise first and second mounting holes, and first and second spring retaining clips. The first and second mounting holes may be disposed on opposing sides of the fitting. Similarly, the first and second spring retaining clips may be disposed on opposing sides of the fitting. In examples, the fitting may comprise more than two mounting holes and/or more than two spring retaining clips.

In examples, the fitting may further comprise a power supply unit. The power supply unit may be housed within a recess formed in the fitting. The power supply unit may comprise one or more terminals for attachment to an external power source. The power supply unit may additionally comprise one or more terminals for external control cables, for example of a building control network. The fitting may include a cable clamp for clamping cables to the fitting. The fitting may include a removable cover for covering the power supply unit. The removable cover may act as a part of the cable clamp.

In examples, the fitting may further comprise a clip for attaching the building control sensor to the fitting. The clip may removably attach the building control sensor to the fitting. In examples, the clip comprises a resiliently deflectable prong protruding from the fitting and arranged to engage a clip hole of the building control sensor.

In examples, the fitting may further comprise a connector arranged to provide an electrical connection between the fitting, in particular the power supply unit, and the building control sensor when the building control sensor is attached to the fitting.

In examples, the fitting comprises a first housing portion and a second housing portion. In examples, the power supply unit is disposed in a recess formed between the first and second housing portions. In examples, the first housing portion is positionable against the surface when the fitting is surface mounted, and the building control sensor is attachable to the second housing portion.

According to a second aspect of the present invention, there is also provided a building control sensor system comprising of the fitting described above and a building control sensor attachable to the fitting.

In examples, the building control sensor system further comprises a sleeve for surrounding the fitting when the fitting is attached to the surface via the one or more mounting holes. In examples, the building control sensor comprises a flange. The sleeve may be positionable between the surface and the flange during use.

In examples, the building control sensor is a lighting control sensor. For example, the building control sensor may comprise a sensor configured to detect one or more of movement, motion, presence, absence, and/or occupancy. The building control sensor may comprise a passive infrared (PIR) sensor. The building control sensor may comprise a sensor and a lens.

In other examples, the lighting control sensor may be a light level sensor adapted to detect an environment light level. In other examples the lighting control sensor may detect other environment characteristics for controlling lighting.

In other examples, the building control sensor may comprise a fire alarm sensor, for example a smoke or heat detector. In other examples, the building control sensor may comprise a gas sensor, for example a carbon monoxide sensor or sensor for other gases, particularly noxious gases.

In some examples, there is provided a kit of parts comprises the fitting described above and a sleeve positionable to surround the fitting when the fitting is surface-mounted using the one or more mounting holes. In some examples, the kit comprises a plurality of fittings and a plurality of sleeves, where the number of sleeves may be less than the number of fittings. The fittings in the kit may be compatible with a number of different building control sensors, allowing a single fitting and sleeve kit to be manufactured, stocked and distributed for a variety of building control sensors. Alternatively, the kit may include one or more building control sensors.

According to a third aspect of the invention there is also provided a shield attachment for a building control sensor having a housing and a lens, the shield attachment comprising a frame attachable to the building control sensor and a shield element movably mounted to the frame and movable relative to the lens of the building control sensor to adjust a field of view of the building control sensor.

In examples, the frame comprises a clip for attaching the shield attachment to the building control sensor. In particular, the clip may attach to a housing or flange of the building control sensor, proximate to a lens of the building control sensor. The clip may comprise a plurality of clip members. The clip may be configured such that the shield attachment can be attached to the building control sensor in a plurality of different orientations. One orientation may be perpendicular to another orientation. In some examples, the frame may be rotatable relative to the lens so that the frame can be positioned in any orientation.

In examples, the frame may comprise a rail and the shield element may be slidable along the rail. In examples, the shield element may comprise a sliding portion adapted to partially wrap around the rail such that the shield element can slide along the rail. In examples, the sliding portion may be adapted to be a friction fit with the rail.

In examples, the shield attachment may further comprise a second shield element. The second shield element may be movably mounted to the frame and movable relative to the shield element. The shield element and second shield element may be mounted on opposite sides of the lens and moveable to cover, or expose, different parts of the lens.

In examples, the lens of the building control sensor is convex, and wherein the shield member comprises a part-spherical moulding to at least partially accommodate the lens. In examples, the shield member is semi-spherical. The second shield member may be identical to the shield member. In particular, the second shield element may be movably mounted to the frame and movable relative to the shield element. The second shield element may comprise a part-spherical moulding to at least partially accommodate the lens. The second shield member may comprise be semi-spherical. In examples, the shield element and the second shield element are positionable to completely cover the lens.

According to a fourth aspect of the present invention there is also provided a building control sensor comprising a housing and a lens, the housing having a clip for attachment of the shield attachment described above.

In examples, the building control sensor comprises the shield attachment described above.

In examples, the clip of the building control sensor comprises a plurality of clip holes or clip prongs. In examples, the clip of the building control sensor is configured such that the shield attachment can be attached in a plurality of different orientations, for example perpendicular orientations.

In examples, the building control sensor is a lighting control sensor. For example, the building control sensor may comprise a sensor configured to detect one or more of movement, motion, presence, absence, and/or occupancy. The building control sensor may comprise a passive infrared (PIR) sensor. The building control sensor may comprise a sensor and a lens.

In other examples, the lighting control sensor may be a light level sensor adapted to detect an environment light level. In other examples the lighting control sensor may detect other environment characteristics for controlling lighting.

In other examples, the building control sensor may comprise a fire alarm sensor, for example a smoke or heat detector. In other examples, the building control sensor may comprise a gas sensor, for example a carbon monoxide sensor or sensor for other gases, particularly noxious gases.

It will be appreciated that different aspects of the present invention may be combined together. For example, a building control sensor system may comprise a fitting for mole-mounting or surface-mounting, as described above, and also a building control sensor with the shield attachment as described above.

### BRIEF DESCRIPTION OF THE DRAWINGS

Examples of the invention are further described hereinafter with reference to the accompanying drawings, in which:
FIGS. 1A and 1B illustrate a building control sensor with a fitting in a hole mounting configuration;
FIGS. 2A and 2B illustrate a building control sensor with a fitting in a surface mounting configuration;
FIG. 3 illustrates the separation of the building control sensor from the fitting;
FIG. 4 illustrates the fitting in isolation;
FIG. 5 illustrates the building control sensor in isolation;
FIG. 6 illustrates features of a power supply unit of the fitting;
FIG. 7 illustrates the mounting features of the fitting;
FIG. 8 illustrates a magnified view of the mounting features of the fitting;
FIG. 9 illustrates a cross-section of the fitting, in particular the mounting features;
FIG. 10 illustrates an exploded view of the fitting;
FIG. 11 illustrates a part of a cover for the fitting;
FIG. 12 illustrates a building control sensor with a shield frame attached thereto;
FIG. 13 illustrates a shield attached to the building control sensor; and
FIG. 14 illustrates the shield frame and shield of FIGS. 13 and 14.

### DETAILED DESCRIPTION

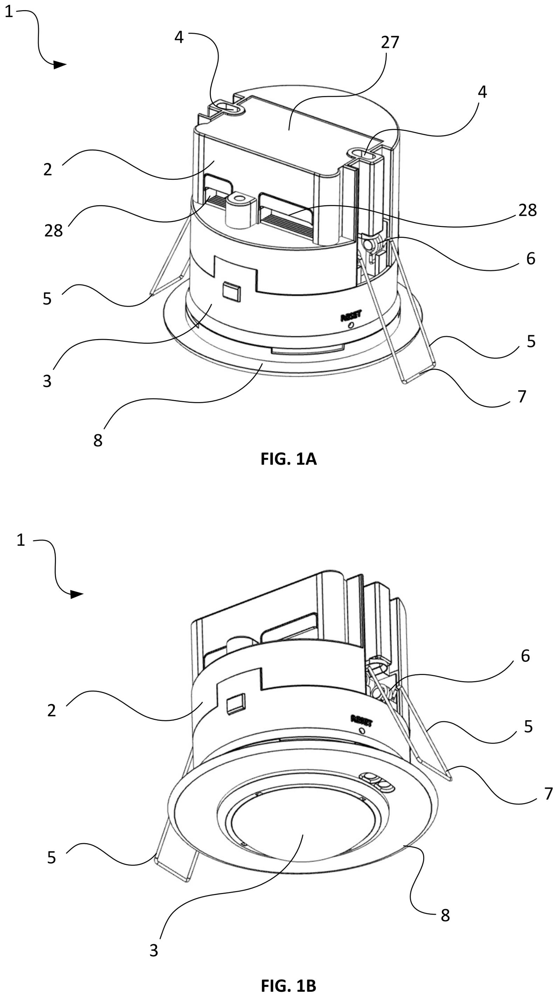

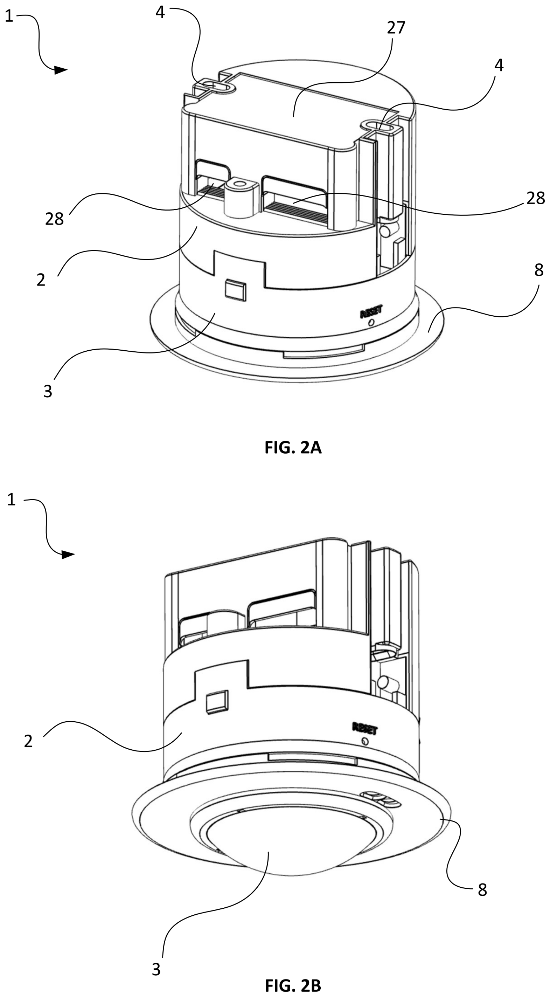

As illustrated in FIGS. 1A to 2B, the present invention relates to a fitting 2 for mounting a building control sensor 3 to a surface. The fitting 2 has a mounting hole 4 for screwing the fitting to a surface in a surface-mounted configuration. The fitting 2 also has a spring retaining clip 5 adapted to retain the fitting 2 within a hole formed in a surface in a hole-mounting configuration. Accordingly, the fitting 2 can be configured for hole-mounting, as shown in FIGS. 1A and 1B, or for surface-mounting, as shown in FIGS. 2A and 2B. FIGS. 1A to 2B illustrate a building control sensor system 1 that includes the fitting 2 and the building control sensor 3.

As shown in FIGS. 1A and 1B, in the hole-mounting configuration there are two spring retaining clips 5 arranged on opposite sides of the fitting 2. The spring retaining clips 5 each comprise a torsion spring portion 6 mounted at the fitting 2, and an arm 7 extending from the torsion spring portion 6. During use, the fitting 2 and a part of the building control sensor 3 extend through a hole formed in the surface. The building control sensor 3 includes a flange 8 that abuts a first side of the surface, and the torsion spring portions 6 bias the arms 7 against the opposite side of the surface so that the spring retaining clips 5 act against the flange 8 to mount the building control sensor system 1 in the hole.

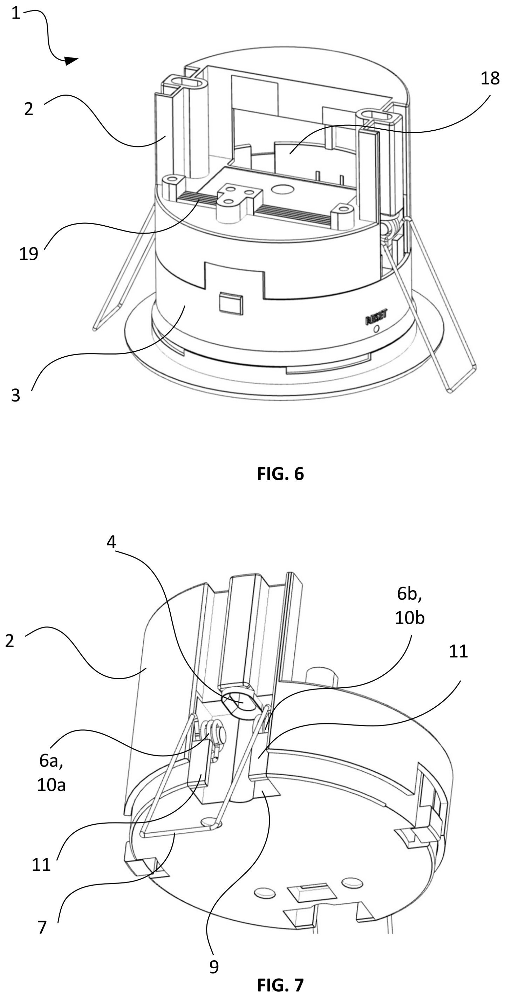

As shown more clearly in FIGS. 7 to 9, the fitting 2 comprises a mounting recess 9 for each spring retaining clip 5. Within the mounting recess 9 two spigots 10a, 10b extend towards each other and each spigot 10a, 10b. The torsion spring portion 6 comprises two parts 6a, 6b that are spaced apart. The arm 7 extends from the part 6a of the torsion spring portion 6, away from the fitting 1, and back to the second part 6b of the torsion spring portion 6. The two spigots 10a, 10b engage, respectively, the first and second parts 6a, 6b of the torsion spring portion 6 of the spring retaining clip 5. In this way, the spring retaining clips 5 are attached to the fitting 2 at the spigots 10a, 10b. A stopper 11 is arranged to engage a free end 12 of the torsion spring portion 6 of each spring retaining clip 5 to restrict rotation of the spring retaining clip 5 and allow the torsion spring portion 6 to bias the arms 7 as described above.

As illustrated, the two spigots 10a, 10b extend from sidewalls 13 of each mounting recess 9. The two spigots 10a, 10b are parallel to each other and spaced apart. Accordingly, the spring retaining clips 5 can be detached from the fitting 2 by deflecting the two parts 6a, 6b of the spring retaining clips 5 towards each other and removing them from the spigots 10a, 10b through the gap between the spigots 10a, 10b. Accordingly, the fitting 2 can be adapted for surface-mounting by removing the spring retaining clips 5.

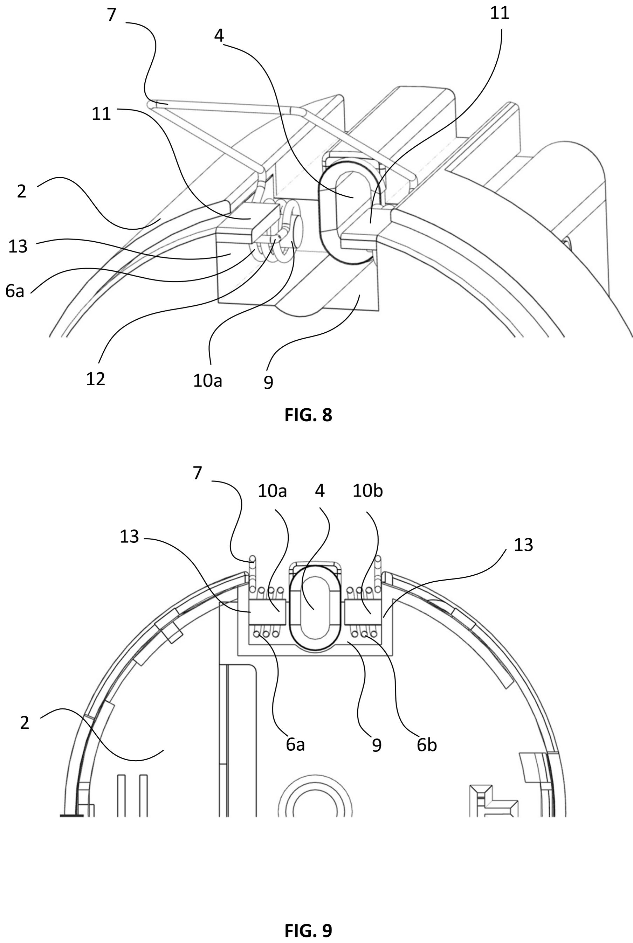

As shown in FIG. 9, the mounting hole 4 is aligned with the spring retaining clip 5. In particular, the mounting hole 4 extends from the mounting recess 9, and the spigots 10a, 10b are arranged proximal to the mounting hole 4 in the mounting recess 9. Accordingly, the mounting holes 4 may be unusable when the spring retaining clips 5 are attached to the fitting 2.

In the configuration illustrated in FIGS. 2A and 2B the spring retaining clips (5, see FIG. 1A) have been removed as described above and the fitting 2 can be used for surface-mounting by the mounting holes 4. The mounting holes 4 extend through a part of the fitting 2 and allow a screw (or bolt or other fastener) to pass through for attaching the fitting 2 to the surface.

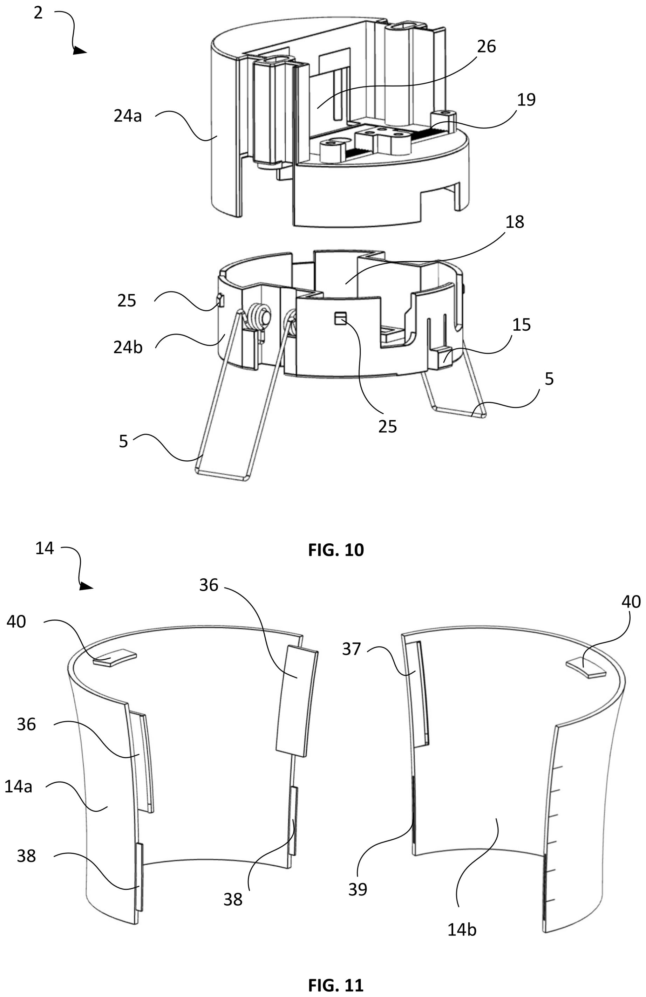

A sleeve 14, such as that illustrated in FIG. 11, may be positioned between the surface and the flange 8 on the building control sensor 3 to cover the fitting 4. The sleeve 14 additionally covers parts of the building control sensor 3 located on the side of the flange 8 facing the fitting 2. The sleeve 14 is used when the fitting 2 is surface-mounted using the mounting holes 4, so that the fitting 2 and parts of the building control sensor 3 are not visible once installed. The sleeve 14 thereby improves the appearance of the building control sensor system 1, and also provides protection for the fitting 2 and electronics housed therein.

As shown in FIG. 11, the sleeve 14 may be formed of two parts 14a, 14b that clip together about the fitting 2. The sleeve 14 has a substantially cylindrical shape when assembled, although it may include a taper or curve to accommodate the fitting 2 and to improve the aesthetics of the sleeve 14.

The first part 14a can have male connector parts 36, and the second part 14b can have female connector parts 37. The male connector parts 36 may be resiliently deformable and configured to clip into the female connector parts 37. The first part 14a may also include alignment ribs 38 that engage with alignment grooves 49 formed in the second part 14b to ensure alignment between the first and second parts 14a, 14b of the sleeve 14.

As shown, one or both of the first and second parts 14a, 14b may also include a retaining member 40 arranged to engage a part of the fitting 2 such that the sleeve 14 is held in place on the fitting 2 even if the building control sensor 3 is removed. This allows the sleeve 14 to be positioned before attaching the building control sensor 3, and also means that the building control sensor 3 can be removed and the sleeve 14 can stay in place. Additionally, providing the sleeve 14 in two parts 14a, 14b that clip together allows the sleeve 14 to be installed (i.e., positioned about the fitting 2) after the fitting 2 has been attached to the surface and after the building control sensor 3 has been attached.

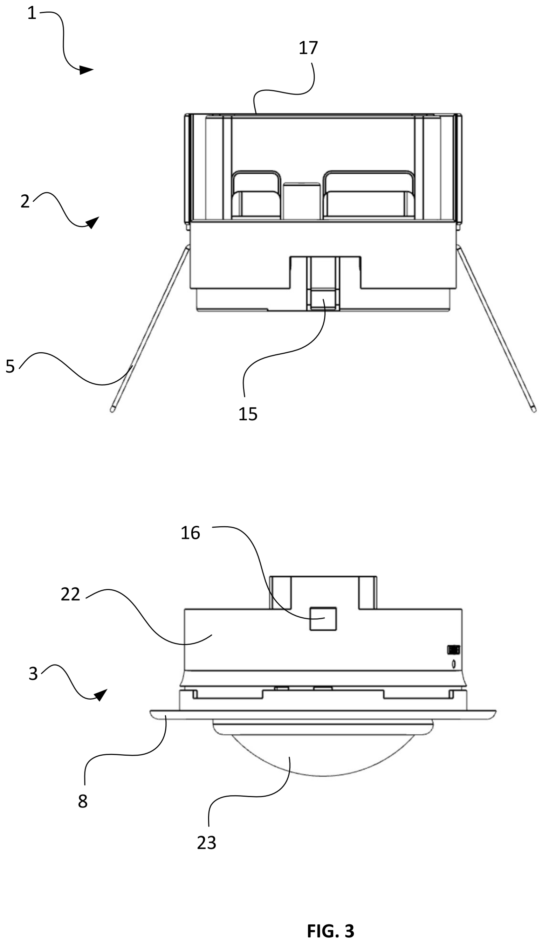

As shown in FIGS. 3 to 5, the building control sensor 3 is detachable from the fitting 2. In particular, the fitting 2 includes the mounting holes (not visible in FIG. 3) and spring retaining clips 5, and two clip members 15 for attaching to the building control sensor 3. The building control sensor 3 includes two clip holes 16 that correspond to the clip members 15 of the fitting 2. The clip members 15 are resiliently deflectable prongs that engage the clip holes 16 to removably secure the building control sensor 3 to the fitting 2.

The fitting 2 has a mounting surface 17 that is placed against the surface in the surface-mounted configuration (FIGS. 2A and 2B), and the building control sensor 3 is attachable to a side of the fitting 2 opposite to the mounting surface 17. In this way the building control sensor 3 is directed into the room (i.e., away from the surface) when mounted.

As most clearly illustrated in FIG. 6, the fitting 2 comprises a power supply unit. In particular, the fitting 2 comprises a recess 18 within which power terminals can be mounted. The fitting 2 also includes a cable clamp 19 for securing one or more cables to the fitting 2, which are then connected to a power supply unit housed in the recess 18. The power supply unit may be connected to power cables in the building. The power supply unit may additionally have one or more control cable connections for connection to a building control network. In this way, the fitting 2 can provide power and control connections between a building power and control network and the building control sensor system 1.

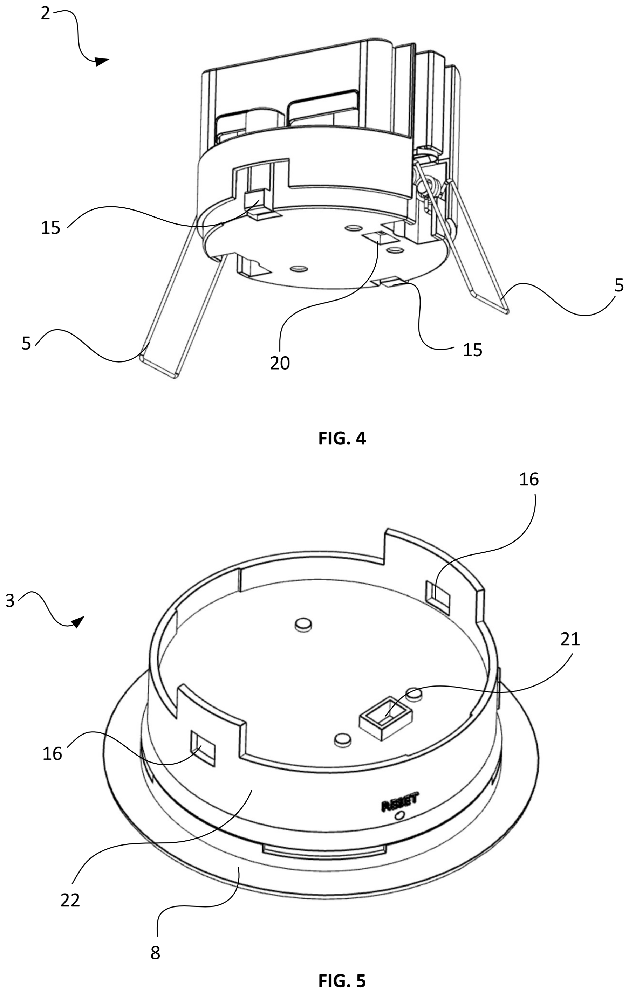

As shown in FIG. 4, the fitting 2 has an electrical connector 20 that faces the building control sensor 3 when the building control sensor 3 is attached to the fitting 2. As shown in FIG. 5, the building control sensor 3 has an electrical connector 21 that corresponds with, and connects to, the electrical connector 20 on the fitting when the building control sensor 3 is attached to the fitting 2. In this way, power and control at the power supply unit in the fitting 2 can be provided to the building control sensor 3.

As shown in FIGS. 3 and 5, the building control sensor 3 includes a housing 22, of which the flange 8 is a part. The building control sensor 3 also includes a lens 23. The lens 23 is partly spherical and protrudes away from the surface to which the fitting 2 is mounted. Within the building control sensor 3 are one or more sensors, and optionally a controller and/or other electronics for operating the sensor(s). The sensor(s) may be movement sensors, motion sensors, presence sensors, absence sensors, occupancy sensors, passive infrared (PIR) sensors, or others.

As shown in FIG. 10, the fitting 2 comprises a first housing part 24a and a second housing part 24b. The first and second housing parts 24a, 24b are attached to each other through clips 25 on the second housing part 24b that engage corresponding recesses (not shown) on the first housing part 24a. The clips 25 permit detachment of the first and second housing parts 24a, 24b. The power supply unit described above may be located in the recess 18 formed between the first and second housing parts 24a, 24b, and an opening 26 permits passage of cables into the recess 18. A cover 27 (see FIGS. 1A and 2A) may partially cover the opening 26. The cover 27 includes holes 28 for the cables to pass through. The cover 27 may form a part of the cable clamp 19 shown in FIG. 6.

As shown in FIG. 10, the clip members 15 may be formed on the second housing part 24b. Also, the spring retaining clips 5 may be attached to the second housing part 24b.

In this way, the fitting 2 can be assembled by positioning the power supply unit in the recess 18 of the second housing part 24b and then attaching the first and second housing parts 24a, 24b to each other.

The building control sensor system 1 described above may be provided as a kit. The kit may include the fitting 2 with mounting holes 4 and spring retaining clips 5, the building control sensor 3, and the sleeve 14. With this kit the installer can either hole-mount the fitting 2 using the spring retaining clips 5, or surface-mount the fitting 2 by removing the spring retaining clips 5 and using the mounting holes 4 and sleeve 14. In other examples, the fitting 2 and sleeve 14 may be provided to the installer as a kit that is compatible with a number of different building control sensors 3, thereby allowing a single fitting 2 to be stocked and transported for use with various building control sensors 3.

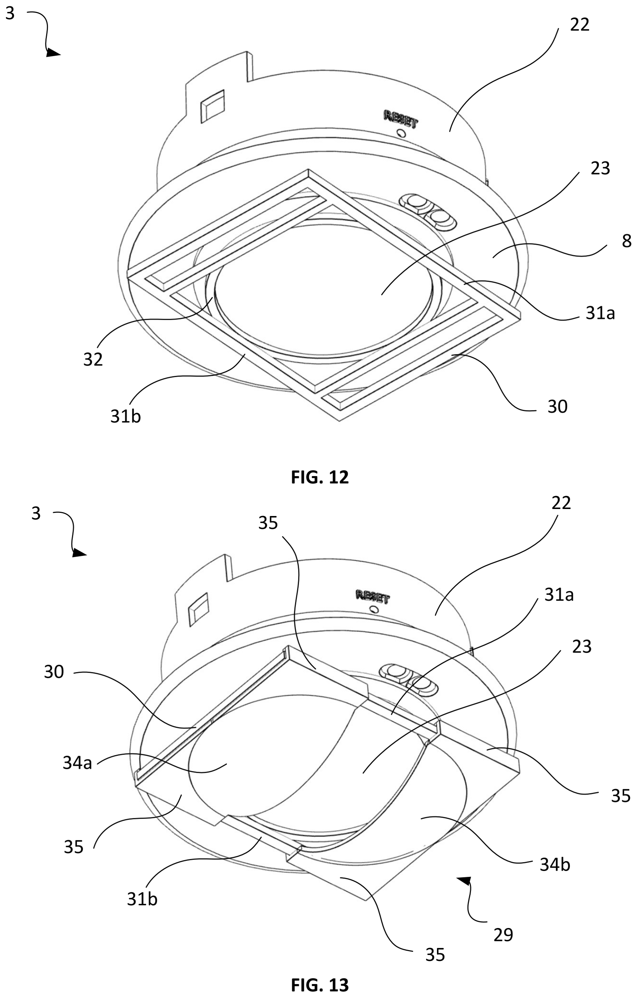

FIGS. 12 to 14 illustrate an additional feature of the building control sensor system 1 described above. In particular, FIGS. 12 to 14 illustrate a shield attachment 29 for the building control sensor 3. The shield attachment 29 has a frame 30 that can be attached to the building control sensor 3, around the lens 23. The shield attachment 29 further has a moveable shield element 34 that attaches to the frame 30 and can move along the frame 30. Movement of the shield element 31 changes a field of view of the building control sensor 3 as described further hereinafter.

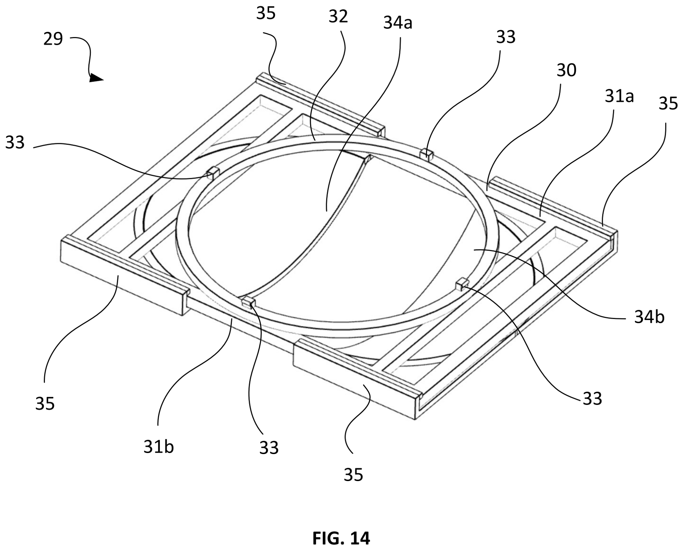

As shown in FIGS. 12 and 14, the frame 30 of the shield attachment 29 is quadrangular and has parallel rails 31a, 31b that, when attached to the building control sensor 3, are positioned on opposite sides of the lens 23. The frame 30 also includes a mounting portion 32 that includes clips 33 for attachment to corresponding clip holes on the building control sensor 3, about the lens 23. In this way, the frame 30 can be attached to the building control sensor 3 such that the rails 31a, 31b extend along opposite sides of the lens 23 as shown in FIG. 12. As shown, the frame 30 comprises four clips 33 equally spaced about the mounting portion 32. Accordingly, the frame 30 can be attached to the building control sensor in a number of orientations. Further, intermediate, clips 33 may be provided to increase the number of potential mounting orientations. In some examples, the clips 33 on the frame 30 may engage a circular groove or lip on the building control sensor 3, for example an edge of the lens 23, such that the shield attachment 29 can be freely rotated relative to the lens 23.

As shown in FIGS. 13 and 14, two shield elements 34a, 34b are attachable to the frame 30, in particular the rails 31a, 31b. The shield elements 34a, 34b comprise sliding portions 35 that partially wrap-around the rails 31a, 31b and allow the shield elements 34a, 34b to slide along the rails 31a, 31b. The sliding portions 35 may be a friction fit on the rails 31a, 31b so that the shield elements 34a, 34b are securely held in place but able to be moved by application of force by an installer. Alternatively, a lock may be provided, for example a grub screw or similar fastener for locking the position of the shield elements 34a, 34b on the frame 30.

The shield elements 34a, 34b also comprise a moulded portion that substantially matches the shape of the lens 23. In this way, the shield elements 34a, 34b can be moved, independently, to each partially cover the lens 23 and change a field of view of the lens 23.

The shield attachment 29 provides a simple and effective way of changing the field of view of the building control sensor 3. In particular, the shield members 34a, 34b can be independently slid along the rails 31a, 31b to change a separation between the shield members 34a, 34b and change the part of the lens 23 that is exposed. In addition, the shield attachment 29 can be detached from the building control sensor 3 and reattached in a different orientation (or rotated relative to the building control sensor 3), thereby changing the sliding direction of the shield members 34a, 34b and the field of view. Accordingly, the field of view can be adjusted based on where the building control sensor 3 is mounted and other requirements of the installation. For example, the shield members 34a, 34b can be positioned relatively close to each other to limit the field of view to a corridor or other limited space, or if the building control sensor is in a high bay mounting position (i.e., mounted high relative to the floor). In other examples, the shield members 34a, 34b can be moved apart to increase the field of view of the building control sensor 3, for example for mounting on a regular height ceiling or where a wide field of view is otherwise desirable.

The clips 33 allow the shield attachment 29 to be easily attached and detached as needed. Not all installations will require the shield attachment 29, so because of the clips 33 it can be omitted when not required.

As explained with reference to FIGS. 1 to 11, the building control sensor system 1 described herein can be mounted in either a hole-mounted configuration using the spring retaining clips 5 (see FIGS. 1A and 1B), or in a surface-mounted configuration by removing the spring retaining clips (see FIGS. 2A and 2B). Accordingly, only one type of fitting 2 needs to be manufactured, stocked, and supplied for hole mounting and surface mounting, and the installer can make the necessary configuration on site. In addition, the shield attachment 29 described with reference to FIGS. 12 to 14 provides additionally configurability, as the shield attachment 9 can be adjusted based on the specific installation site and without the need for specific components or cutting/breaking components. The shield attachment 29 can also be adjusted or removed if the installation site requirements change.

In the various examples described above the building control sensor 3 is a lighting control sensor, for example to detect movement, motion, presence, absence, and/or occupancy. The sensors may include a passive infrared (PIR) sensor. In other examples, the lighting control sensor may be a light level sensor adapted to detect an environment light level. In other examples the lighting control sensor may detect other environment characteristics for controlling lighting.

In other examples, the building control sensor 3 may comprise a fire alarm sensor, for example a smoke or heat detector. In other examples, the building control sensor 3 may comprise a gas sensor, for example a carbon monoxide sensor or sensor for other gases, particularly noxious gases.

Accordingly, the fitting 2 described with reference to FIGS. 1 to 11 may be used to mount any building control sensor to a surface, for example a ceiling or a wall.

Throughout this specification, the words "comprise" and "contain" and variations of them mean "including but not limited to", and they are not intended to (and do not) exclude other components, integers or steps. Throughout this specification, the singular encompasses the plural unless the context otherwise requires. In particular, where the indefinite article is used, the specification is to be understood as contemplating plurality as well as singularity, unless the context requires otherwise. Throughout this specification, the term "about" is used to provide flexibility to a range endpoint by providing that a given value may be "a little above" or "a little below" the endpoint. The degree of flexibility of this term can be dictated by the particular variable and can be determined based on experience and the associated description herein.

Features, integers or characteristics described in conjunction with a particular aspect or example of the invention are to be understood to be applicable to any other aspect or example described herein unless incompatible therewith. All of the features disclosed in this specification, and/or all of the steps of any method or process so disclosed, may be combined in any combination, except combinations where at least some of such features and/or steps are mutually exclusive. The invention is not restricted to the details of any foregoing examples. The invention extends to any novel feature or combination of features disclosed in this specification. It will be also be appreciated that, throughout this specification, language in the general form of "X for Y" (where Y is some action, activity or step and X is some means for carrying out that action, activity or step) encompasses means X adapted or arranged specifically, but not exclusively, to do Y.

Each feature disclosed in this specification may be replaced by alternative features serving the same, equivalent or similar purpose, unless expressly stated otherwise. Thus, unless expressly stated otherwise, each feature disclosed is one example only of a generic series of equivalent or similar features.

The reader's attention is directed to all papers and documents which are filed concurrently with or previous to this specification in connection with this application and which are open to public inspection with this specification, and the contents of all such papers and documents are incorporated herein by reference.

### Clauses

1. A fitting for mounting a building control sensor to a surface, the fitting comprising:
   a mounting hole for screwing the fitting to the surface, and,
   a spring retaining clip adapted to retain the fitting within a hole formed in the surface.
2. The fitting of clause 1, wherein the spring retaining clip is removeable.
3. The fitting of clause 1 or clause 2, wherein the spring retaining clip is mounted in a recess of the fitting.
4. The fitting of any preceding clause, wherein the fitting comprising a planar face arranged to abut the surface when using the mounting hole, and wherein the mounting hole is perpendicular to the planar face.
5. The fitting of any preceding clause, comprising first and second mounting holes and first and second spring retaining clips.
6. The fitting of any preceding clause, further comprising a power supply unit.
7. The fitting of clause 6, further comprising a removable cover for covering the power supply unit.
8. The fitting of any preceding clause, further comprising a clip for attaching the building control sensor to the fitting.
9. The fitting of clause 8, wherein the clip comprises a resiliently deflectable prong protruding from the fitting and arranged to engage a clip hole of the building control sensor.
10. The fitting of clause 8 or clause 9, further comprising a connector arranged to provide an electrical connection between the fitting, in particular the power supply unit, and the building control sensor when the building control sensor is attached to the fitting.
11. The fitting of any of clauses 8 to 10, wherein the fitting comprises a first housing portion and a second housing portion.
12. A building control sensor system comprising of the fitting of any preceding clause and a building control sensor attachable to the fitting.
13. The building control sensor system of clause 12, wherein the building control sensor is a lighting control sensor or a fire alarm.
14. A shield attachment for a building control sensor having a housing and a lens, the shield attachment comprising a frame attachable to the building control sensor and a shield element movably mounted to the frame and movable relative to the lens of the building control sensor to adjust a field of view of the building control sensor.
15. The shield attachment of clause 14, wherein the frame comprises a clip for attaching the shield attachment to the building control sensor.
16. The shield member of clause 14 or clause 15, wherein the clip is configured such that the shield attachment can be attached to the building control sensor in a plurality of different orientations.
17. The shield attachment of any preceding clause, wherein the frame comprises a rail and the shield element is slidable along the rail.
18. The shield attachment of clause 17, wherein the shield element comprises a sliding portion adapted to partially wrap around the rail such that the shield element can slide along the rail.
19. The shield attachment of clauses 14 to 18, further comprising a second shield element.
20. The shield attachment of clause 19, wherein the second shield element is movably mounted to the frame and movable relative to the shield element.
21. The shield attachment of any of clauses 14 to 20, wherein the lens of the building control sensor is convex, and wherein the shield member comprises a part-spherical moulding to at least partially accommodate the lens.
22. The shield attachment of clause 21, further comprising a second shield element movably mounted to the frame and movable relative to the shield element, the second shield element comprising a part-spherical moulding to at least partially accommodate the lens.
23. A building control sensor comprising a housing and a lens, the housing having a clip feature for attachment of the shield attachment of any preceding clause.
24. The building control sensor of clause 23, further comprising the shield attachment of any preceding clause.
25. The building control sensor of clause 23 or clause 24, wherein the building control sensor is a lighting control sensor.

## Claims

1. A shield attachment for a building control sensor having a housing and a lens, the shield attachment comprising a frame attachable to the building control sensor and a shield element movably mounted to the frame and movable relative to the lens of the building control sensor to adjust a field of view of the building control sensor.

2. The shield attachment of claim 1, wherein the frame comprises a clip for attaching the shield attachment to the building control sensor.

3. The shield member of claim 11 or claim 12, wherein the clip is configured such that the shield attachment can be attached to the building control sensor in a plurality of different orientations.

4. The shield attachment of any preceding claim, wherein the frame comprises a rail and the shield element is slidable along the rail.

5. The shield attachment of claim 4, wherein the shield element comprises a sliding portion adapted to partially wrap around the rail such that the shield element can slide along the rail.

6. The shield attachment of claims 1 to 5, further comprising a second shield element.

7. The shield attachment of claim 6, wherein the second shield element is movably mounted to the frame and movable relative to the shield element.

8. The shield attachment of any of claims 1 to 7, wherein the lens of the building control sensor is convex, and wherein the shield member comprises a part-spherical moulding to at least partially accommodate the lens.

9. The shield attachment of claim 8, further comprising a second shield element movably mounted to the frame and movable relative to the shield element, the second shield element comprising a part-spherical moulding to at least partially accommodate the lens.

10. A building control sensor comprising a housing and a lens, the housing having a clip feature for attachment of the shield attachment of any preceding claim.

11. The building control sensor of claim 10, further comprising the shield attachment of any preceding claim.

12. The building control sensor of claim 10 or claim 11, wherein the building control sensor is a lighting control sensor.
